(19)

**Europäisches Patentamt**
**European Patent Office**
**Office européen des brevets**

(11) **EP 4 564 668 A1**

(12) **EUROPEAN PATENT APPLICATION**

(43) Date of publication:
**04.06.2025 Bulletin 2025/23**

(21) Application number: **23212979.1**

(22) Date of filing: **29.11.2023**

(51) International Patent Classification (IPC):
**H03K 5/24** (2006.01)

(52) Cooperative Patent Classification (CPC):
**H03K 5/2481**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP USA, Inc.**
**Austin TX 78735 (US)**

(72) Inventor: **Shuvalov,, Denis Sergeevich**
**5656 AG Eindhoven (NL)**

(74) Representative: **Schmütz, Christian Klaus
Johannes**
**NXP Semiconductors Germany GmbH**
**Intellectual Property Group**
**Beiersdorfstr. 12**
**22529 Hamburg (DE)**

(54) **A CURRENT COMPARATOR**

(57)     A current comparator comprising: a P-type metal oxide semiconductor field effect transistor, PMOS FET (614), and an N-type metal oxide semiconductor field effect transistor, NMOS FET (615). The source of the PMOS FET is connected to a first comparator input terminal (610). The source of the NMOS FET is connected to a second comparator input terminal (611). The drain of the PMOS FET is connected to a current-comparator-input-node (602). The drain of the NMOS FET is connected to the current-comparator-input-node. The gate of the PMOS FET is connected to a first bias-voltage-node (VP). The gate of the NMOS FET is connected to a second bias-voltage-node (VN). The current comparator also includes a bias circuit (613) that provides a bias voltage to each of the first and second bias-voltage-nodes, and a current-comparator-circuit (601). A current-comparator-circuit-input-terminal (602) is connected to the current-comparator-input-node in order to receive a difference-current-input signal (IIn), which is representative of the difference between a first current input signal and a second current input signal. The current-comparator-circuit is configured to provide a current comparator output signal (Vout) as a digital voltage signal based on the received difference-current-input signal.

Figure 6

EP 4 564 668 A1

## Description

## Field

The present disclosure relates to current comparators, and in particular to current comparators that have a fast operational speed.

## Summary

According to a first aspect of the present disclosure there is provided a current comparator comprising:

a first comparator input terminal, which is configured to receive a first current input signal;
a second comparator input terminal, which is configured to receive a second current input signal;
a comparator output terminal;
a P-type metal oxide semiconductor field effect transistor, PMOS FET, and an N-type metal oxide semiconductor field effect transistor, NMOS FET, each having a gate, a drain and a source, wherein:

the source of the PMOS FET is connected to the first comparator input terminal;
the source of the NMOS FET is connected to the second comparator input terminal;
the drain of the PMOS FET is connected to a current-comparator-input-node;
the drain of the NMOS FET is connected to the current-comparator-input-node;
the gate of the PMOS FET is connected to a first bias-voltage-node;
the gate of the NMOS FET is connected to a second bias-voltage-node;

a bias circuit that is configured to provide a bias voltage to each of the first and second bias-voltage-nodes; and
a current-comparator-circuit, comprising a current-comparator-circuit-input-terminal and a current-comparator-circuit-output terminal, wherein:

the current-comparator-circuit-input-terminal is connected to the current-comparator-input-node in order to receive a difference-current-input signal, which is representative of the difference between the first current input signal and the second current input signal;
the current-comparator-circuit-output terminal is connected to the comparator output terminal in order to provide a current comparator output signal; and
the current-comparator-circuit is configured to provide the current comparator output signal as a digital voltage signal based on the received difference-current-input signal.

In one or more embodiments, the current comparator is a continuous time current comparator.
In one or more embodiments, the current-comparator-circuit is configured to implement voltage-current feedback.
In one or more embodiments, the bias circuit is configured to provide the bias voltages such that the PMOS FET and the NMOS FET are maintained in a saturation region during operation of the current comparator.
In one or more embodiments, the current comparator is provided on an integrated circuit.
In one or more embodiments, the NMOS FET and the PMOS FET have a minimum size that is permitted for the signal currents that are intended to be processed by the current comparator and for the technology of the integrated circuit.
In one or more embodiments, the NMOS FET and the PMOS FET are adjacent to the current-comparator-circuit on the integrated circuit.
In one or more embodiments, the current-comparator-circuit comprises:
a first current-comparator-circuit, CCC, NMOS FET, a first CCC PMOS FET, a second CCC PMOS FET, a second CCC NMOS FET, and a CCC-output-node wherein:

the drain of the first CCC NMOS FET is connected to a voltage supply terminal;
the source of the first CCC NMOS FET is connected to the current-comparator-circuit-input-terminal;
the source of the first CCC PMOS FET is connected to the current-comparator-circuit-input-terminal;
the drain of the first CCC PMOS FET is connected to a ground terminal;
the gate of the first CCC PMOS FET is connected to the CCC-output-node;
the gate of the first CCC NMOS FET is connected to the CCC-output-node;
the source of the second CCC PMOS FET is connected to the voltage supply terminal;
the drain of the second CCC PMOS FET is connected to the CCC-output-node;
the drain of the second CCC NMOS FET is connected to the CCC-output-node;
the source of the second CCC NMOS FET is connected to the ground terminal;
the gate of the second CCC PMOS FET is connected to the current-comparator-circuit-input-terminal;
the gate of the second CCC NMOS FET is connected to the current-comparator-circuit-input-terminal; and
the CCC-output-node is connected to the current-comparator-circuit-output terminal.

In one or more embodiments, the current-comparator-circuit further comprises an inverter, which is connected in series between the CCC-output-node and the current-comparator-circuit-output terminal.

In one or more embodiments, the current comparator further comprises one more further current-comparator modules, wherein each of the one more further current-comparator modules comprises:

a first module input terminal, which is configured to receive a first module current input signal;
a second module input terminal, which is configured to receive a second module current input signal;
a module output terminal;
a P-type metal oxide semiconductor field effect transistor, PMOS FET, and an N-type metal oxide semiconductor field effect transistor, NMOS FET, each having a gate, a drain and a source, wherein:

the source of the PMOS FET is connected to the first module input terminal;
the source of the NMOS FET is connected to the second module input terminal;
the drain of the PMOS FET is connected to a current-comparator-module-input-node;
the drain of the NMOS FET is connected to the current-comparator-module-input-node;
the gate of the PMOS FET is connected to the first bias-voltage-node;
the gate of the NMOS FET is connected to the second bias-voltage-node; and

a current-comparator-module-circuit, comprising a current-comparator-module-circuit-input-terminal and a current-comparator-module-circuit-output terminal, wherein:

the current-comparator-module-circuit-input-terminal is connected to the current-comparator-module-input-node in order to receive a module-difference-current-input signal, which is representative of the difference between the first module current input signal and the second module current input signal;
the current-comparator-module-circuit-output terminal is connected to the module output terminal in order to provide a current comparator module output signal; and
the current-comparator-module-circuit is configured to provide the current comparator module output signal as a digital voltage signal based on the received module-difference-current-input signal.

In one or more embodiments, the bias circuit is configured to provide a different bias voltage to each of the first and second bias-voltage-nodes.

In one or more embodiments, the bias circuit is configured to provide the same bias voltage to each of the first and second bias-voltage-nodes.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 show a simple implementation of a current-comparator-circuit, which is an inverter;
Figure 2a shows an example of a circuit that implements a voltage-current feedback technique using capacitive input;
Figure 2b shows another example of a circuit that implements a voltage-current feedback technique using resistive input;
Figure 2c shows another example of a circuit that implements a voltage-current feedback technique using capacitive input and current steering;
Figure 3 shows a current processing network;
Figures 4a and 4b depicts example circuits that reduce input impedance within a current mirror or common gate input stage;
Figure 5 shows a current comparator according to an embodiment of the present disclosure;
Figure 6 shows a current comparator according to another embodiment of the present disclosure; and
Figure 7 shows plots of the transient response of input current / voltage and output voltage of: the current comparator of Figure 6 in SOLID lines; and a circuit that does not include the PMOS FET and the NMOS FET of Figure 6 (that is, a circuit that is similar to that of Figure 2a) in DASHED lines.

## Detailed Description

Continuous time current comparators (CCs) are the main building blocks in several analogue and mixed-mode circuits, such as ADCs (analogue to digital converters), neural network implementations, oscillators, rectifiers and overcurrent protection circuits, for example. It's application is not limited to only current processing blocks however, as the speed of a conventional continuous time voltage comparator, that utilizes an open loop amplifier on its input, can strongly rely on the performance of a current comparator that is the next to the amplifier.

One way of improving the operational speed of a current comparator is to reduce input voltage swing within voltage-current feedback (resistive or capacitive by used classification). Another way of improving the operational speed of a current comparator is to reduce input impedance using current mirrors or a common gate input stage. The second technique can suffer from increased power consumption and lower resolution due to a reduced transimpedance gain. The first technique can be limited by its relatively high input impedance and input capacitance, which are associated with circuits connected to the input and parasitics of input connection routing.

Current mode comparators can have lots of advantages over voltage mode comparators, such as one or more of high speed, low power consumption, low DC (direct current) offset errors, wide bandwidth, low supply voltage requirements, lesser sensitivity to switching noise, and small chip area. A current comparator circuit is a simple current-mode signal processing circuit, which takes a difference current as an input signal and produces a digital output voltage.

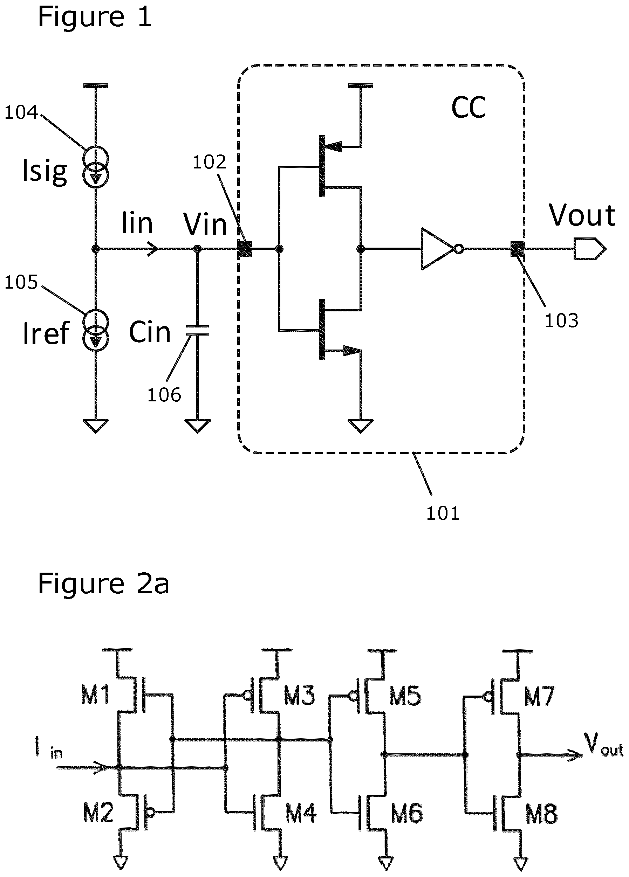

Figure 1 show a simple implementation of a current-comparator-circuit 101, which is an inverter.

The current-comparator-circuit 101 has a current-comparator-circuit-input-terminal 102 and a current-comparator-circuit-output terminal 103.

Figure 1 also shows two current sources: a signal current source, Isig, 104 and a reference current source, Iref, 105. Both of these current sources are connected to the current-comparator-circuit-input-terminal 102 such that it receives a difference-current-input signal, Iin, which is representative of the difference between the two current sources. The current-comparator-circuit 101 provides a current comparator output signal, Vout, at the current-comparator-circuit-output terminal 103 as a digital voltage signal that is based on the received difference-current-input signal, Iin.

Also shown in Figure 1 is an input capacitance, Cin, 106. The input capacitance, Cin, 106 is effective input capacitance on the input 102 of the current-comparator-circuit 101; it represents the capacitance of circuitry connected to the current-comparator-circuit-input-terminal 102, the capacitance of the current-comparator-circuit 101 itself and also the parasitic capacitance of the connections.

The delay of the current-comparator-circuit 101 can be estimated as:

$$ dt \propto C_{in} \frac{\Delta V_{in}}{I_{in}}, $$

where

$C_{in}$ - effective input capacitance of the current-comparator-circuit 101, as discussed above,
$\Delta V_{in}$ - voltage swing on the input of the current-comparator-circuit 101 required for a state change at the current-comparator-circuit-output terminal 103,
$I_{in} = I_{sig} - I_{ref}$ - signal current difference to reference current or input current step on the input of the current-comparator-circuit 101, which is the smallest value that corresponds to a required resolution of the current-comparator-circuit 101.

The minimum delay of the current-comparator-circuit 101 can be reached by minimizing both input capacitance $C_{in}$ and voltage swing $\Delta V_{in}$. To improve operational speed of a current comparators, several techniques based on a reduction of input voltage swing within voltage-current feedback can be used. Current comparators that use voltage-current feedback can be classified as resistive input, transimpedance amplification, or as capacitive input, voltage amplification. Delay can greatly reduced by utilizing feedback that limits the input voltage swing $\Delta V_{in}$, and as positive side effect it also decreases $C_{in}$. This is because a limited swing prevents current mirrors from saturating or, in other words, reduces the likelihood that the current mirrors will go into triode mode in which their drain associated capacitance increases.

Figure 2a shows an example of a circuit that implements a voltage-current feedback technique using capacitive input. The circuit of Figure 2a is known as Traff's comparator circuit.

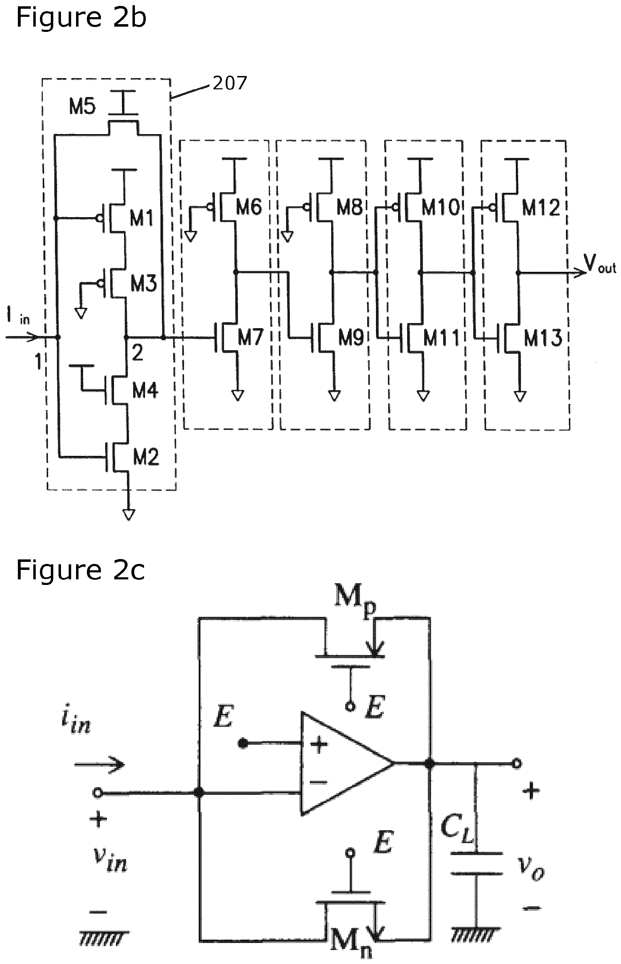

Figure 2b shows another example of a circuit that implements a voltage-current feedback technique using resistive input 207. The circuit of Figure 2b is known as Chen's comparator circuit.

Figure 2c shows another example of a circuit that implements a voltage-current feedback technique using capacitive input and current steering. The circuit of Figure 2c is known as Rodriguez's comparator circuit.

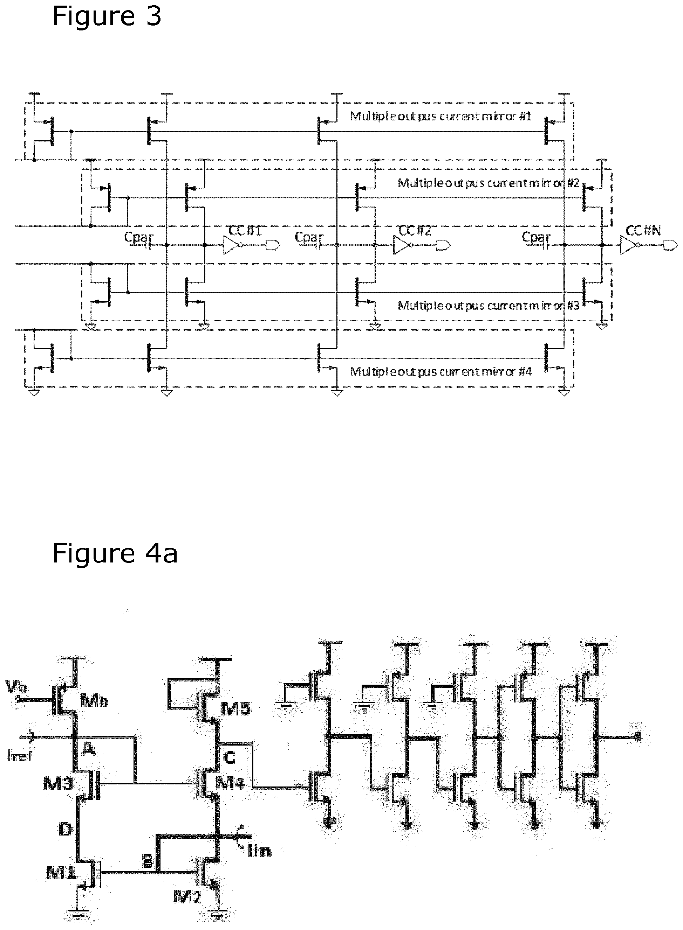

Figure 3 shows a current processing network.

As shown in Figure 3, a current processing network can include a plurality of current comparators connected to different weighted outputs of a plurality of current mirrors. The capacitance, labelled as Cpar in Figure 3, which is formed at the input of each current comparator by the outputs of the connected current mirrors is dictated by current processing complexity, amount and weight current mirrors outputs connected, and accuracy requirements. Preserving matching in layout, together with possible mixture of connections between current mirrors, can restrict minimum connection length and minimum possible capacitance of such connections, which, after LPE (Layout Parasitics Extraction), can be commeasurable with the capacitance coming from current mirrors. This can significantly deteriorate the propagation delay of the current comparator; for example increase them by +50% after LPE simulation.

The presence of such "topology" input capacitance is not alleviated by current comparators with voltage-current feedback. This is due to a relatively high input impedance, which can limit the achievable bandwidth at the input.

The effect from input capacitance of a current comparator can be alleviated by yet another design technique, which reduces input impedance within a current mirror or common gate input stage. Thereby pushing bandwidth at the current comparator's input to higher frequencies.

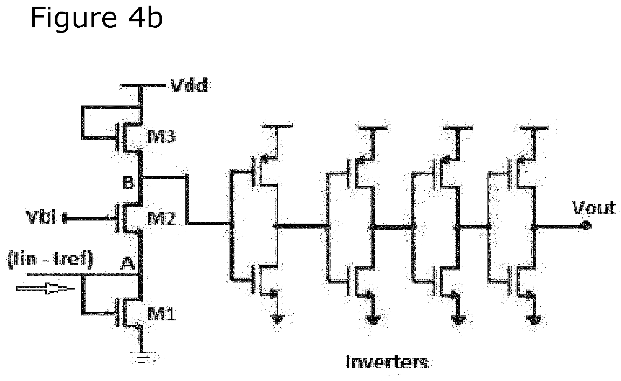

Figures 4a and 4b depicts example circuits that reduce input impedance within a current mirror or common gate input stage. As can be seen, the reduction in input impedance comes at a cost of increased power consumption, lower accuracy, extra mismatch from added devices, and resolution, as the currentvoltage transimpedance gain reduces as well. Also an extra delay is introduced by gain circuitry.

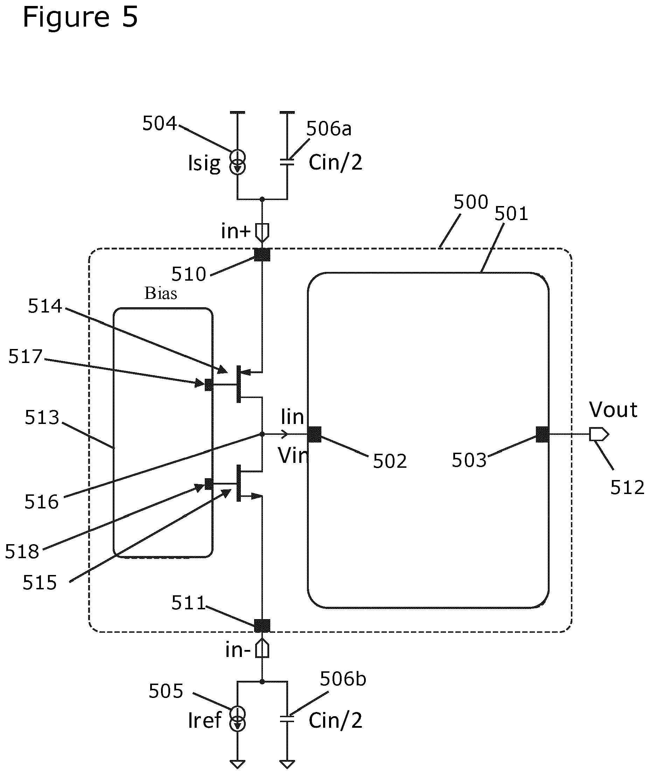

Figure 5 shows a current comparator 500 according to an embodiment of the present disclosure. As will be discussed below, the current comparator 500 of Figure 5 advantageously combines some of the design techniques that are described above without resulting in a power consumption increase or loss of resolution. The current comparator 500 of Figure 5 is a continuous time current comparator.

The current comparator 500 includes a first comparator input terminal 510, a second comparator input terminal 511 and a comparator output terminal 512. The first comparator input terminal 510 receives a first current input signal, which in this example will be referred to as a signal current (Isig). The signal current is represented by a signal current source 504. The second comparator input terminal 511 receives a second current input signal, which in this example will be referred to as a reference current (Iref). The reference current is represented by a reference current source 505. As will be discussed below, the comparator output terminal 512 provides a current comparator output signal, which is a digital representation of the difference between the signal current (Isig) and the reference current (Iref).

The current comparator 500 also includes a P-type metal oxide semiconductor field effect transistor, PMOS FET, 514 and an N-type metal oxide semiconductor field effect transistor, NMOS FET, 515. As is known in the art, each FET disclosed herein has a gate, a drain and a source. The PMOS FET 514 and the NMOS FET 515 are provided in a common gate configuration.

The conduction channels of the PMOS FET 514 and the NMOS FET 515 (i.e., the channel between the drain and the source of the FETs) are connected in series with each other between the first comparator input terminal 510 and the second comparator input terminal 511, such that they define a current-comparator-input-node 516 between the two FETs. As will be discussed below, the current-comparator-input-node 516 provides a difference-current-input signal (Iin) to a current-comparator-circuit 501.

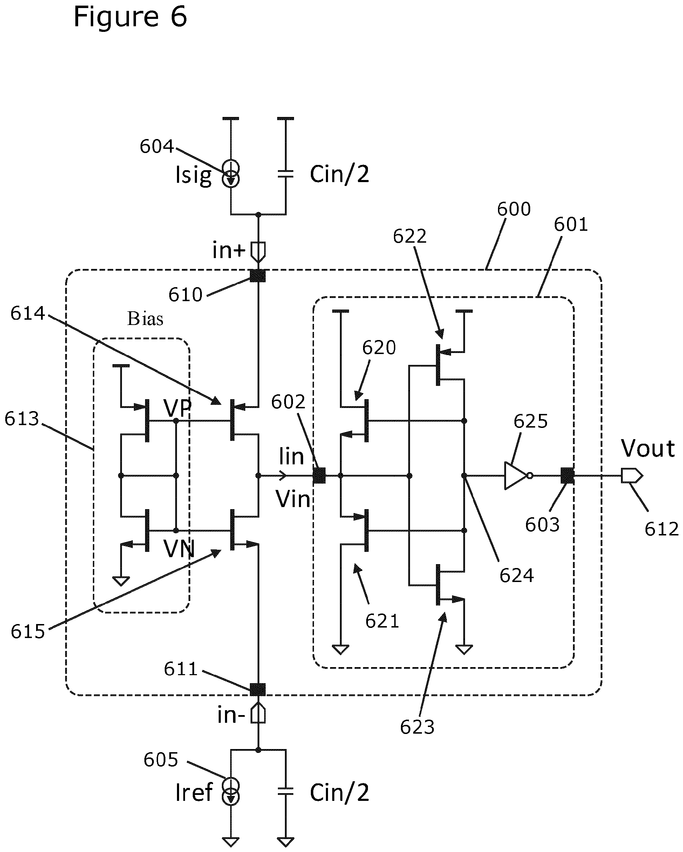

The current comparator 500 also includes a bias circuit 513, which is configured to provide a bias voltage to the PMOS FET 514 and the NMOS FET 515. The bias circuit 513 in this example provides: a first bias voltage to a first bias-voltage-node 517, which is connected to the gate of the PMOS FET 514; and a second bias voltage to a second bias-voltage-node 518, which is connected to the gate of the NMOS FET 515. An example implementation of the bias circuit 513 is illustrated in Figure 6, although it will be appreciated that the bias circuit 513 can be implemented in any way that is known in the art, including feedback circuits such as regulated cascode circuitry. It will be appreciated from Figures 5 and 6 that the same bias voltage can be provided to the gates of each of the PMOS FET 514 and the NMOS FET 515, or different bias voltages can be provided to the gates. For applications that have low voltage constrains, it can be beneficial for different bias voltages to be provided to the gates of the PMOS FET 514 and the NMOS FET 515.

In more detail, the PMOS FET 514 and the NMOS FET 515 of Figure 5 are connected as follows:

the source of the PMOS FET 514 is connected to the first comparator input terminal 510;
the source of the NMOS FET 515 is connected to the second comparator input terminal 511;
the drain of the PMOS FET 514 is connected to the current-comparator-input-node 516;
the drain of the NMOS FET 515 is connected to the current-comparator-input-node 516;
the gate of the PMOS FET 514 is connected to the first bias-voltage-node 517; and
the gate of the NMOS FET 515 is connected to the second bias-voltage-node 518.

The current-comparator-circuit 501 has a current-comparator-circuit-input-terminal 502 and a current-comparator-circuit-output terminal 503. The current-comparator-circuit-input-terminal 502 is connected to the current-comparator-input-node 516, such that it receives the difference-current-input signal (Iin). The difference-current-input signal (Iin) is representative of the difference between the signal current and the reference current. The current-comparator-circuit-output terminal 503 is connected to the comparator output terminal 512 in order to provide the current comparator output signal.

The current-comparator-circuit 501 provides the current comparator output signal as a digital voltage signal based on the received difference-current-input signal (Iin). An example implementation of the current-comparator-circuit 501 is illustrated in Figure 6, although it will be appreciated that the current-comparator-circuit 501 can be implemented in any of a number of different ways while still providing an improved current comparator 500. For instance, the current-comparator-circuit 501 can be implemented in the same way as illustrated in Figures 2a-2c, or any other current-comparator-circuit that implements voltage-current feedback.

An important aspect of the current comparator 500 of Figure 5 is that the input of the current-comparator-circuit 501 is decoupled separately for the input source current branch (i.e., for the signal current source, Isig, 504) and for input sink current branch (i.e., for the reference current source, Iref, 505). This decoupling is achieved by the NMOS FET 515 and the PMOS FET 514, which are in a common gate configuration. Due to their local feedbacks, the impedances on the sources of the PMOS FET 514 and the NMOS FET 515 become as low as $1/G_M$, where $G_M$ is the transconductance of either the PMOS FET 514 or the NMOS FET 515. Beneficially, due to the low impedances on the input terminals for Figure 5, the bandwidth of the input nodes is pushed to relatively high frequencies. Thus, the effects of capacitances associated with current mirrors and physical connections on the delay of the current comparator 500 are alleviated, which is about the same effect that is achieved by the previously mentioned design technique, shown on figures 4a and 4b. At the same time, the effective capacitance on the current-comparator-circuit-input-terminal 502 of the current-comparator-circuit 501 with voltage-current feedback becomes very low. This is especially the case when it is implemented as a self-consistent schematic and layout block, with compact component placement. That is, the current comparator 500 can be implemented on an integrated circuit (IC) with the NMOS FET 515 and the PMOS FET 514 adjacent to the current-comparator-circuit 501.

Figure 6 shows a current comparator 600 according to another embodiment of the present disclosure. Features of Figure 6 that are also shown in Figure 5 are given corresponding reference numbers in the 600 series, and will not necessarily be described again here. The current comparator 600 of Figure 6 is similar to the one of Figure 5, although in Figure 5 example implementations are illustrated for the bias circuit 613 and the current-comparator-circuit 601.

As discussed above, a dedicated bias circuit 613 is used to bias the gates of the PMOS FET 614 and NMOS FET 615, which are provided as common-gate transistors. The bias circuit 613 can be implemented using any one of a variety of suitable circuitries, as will be appreciated by the skilled person. Figure 6 shows a simple implementation of the bias circuit 613.

In applications where there are a plurality of current-comparator-circuits 601, each current-comparator-circuit 601 can have it's own bias circuit 613. Alternatively, a plurality of the current-comparator-circuits 601 can share a common bias circuit 613. In such examples, the current comparator 600 can be considered as having a plurality of current-comparator modules that each receive a bias voltage from the same bias circuit 613. Such current-comparator modules each include:

 a first comparator input terminal 610 (which can be referred to as a first module input terminal 610 for a module);
a second comparator input terminal 611 (which can be referred to as a second module input terminal for a module);
a comparator output terminal 612 (which can be referred to as a module output terminal for a module);
a PMOS FET 614;
an NMOS FET 615; and
a current-comparator-circuit 601 (which can be referred to as a current-comparator-module-circuit for a module).

The bias voltage / potentials that are provided by the bias circuit 613 can be selected to preserve saturation operation regions of the PMOS FET 614 and the NMOS FET 615 as well as any current mirrors that are used to implement the signal current source, Isig, 604 and the reference current source, Iref, 605. This can facilitate limited voltage swing at the input terminal of the current-comparator-circuit 601, which uses voltage-current feedback. In this way, the bias circuit 613 provides a bias voltage such that the PMOS FET 614 and the NMOS FET 615 are maintained in their saturation regions during operation of the current comparator 600, at least for a predetermined range of values for the signal and reference current input signals (Isig and Iref).

We will now describe the non-limiting implementation of the current-comparator-circuit 601 that is shown in Figure 6.

The current-comparator-circuit 601 includes a first CCC NMOS FET 620, a first CCC PMOS FET 621, a second CCC PMOS FET 622, a second CCC NMOS FET 623, and a CCC-output-node 624. Where 'CCC' is label that stands for current-comparator-circuit to signify that the FETs and the node are part of the current-comparator-circuit 601.

The FETs in the current-comparator-circuit 601 are connected as follows:

 the drain of the first CCC NMOS FET 620 is connected to a voltage supply terminal;
the source of the first CCC NMOS FET 620 is connected to the current-comparator-circuit-input-terminal 602;
the source of the first CCC PMOS FET 621 is connected to the current-comparator-circuit-input-terminal 602;
the drain of the first CCC PMOS FET 621 is connected to a ground terminal;
the gate of the first CCC PMOS FET 621 is connected to the CCC-output-node 624;
the gate of the first CCC NMOS FET 620 is connected to the CCC-output-node 624;
the source of the second CCC PMOS FET 622 is connected to the voltage supply terminal;
the drain of the second CCC PMOS FET 622 is connected to the CCC-output-node 624;

the drain of the second CCC NMOS FET 623 is connected to the CCC-output-node 624;
the source of the second CCC NMOS FET 623 is connected to the ground terminal;
the gate of the second CCC PMOS FET 622 is connected to the current-comparator-circuit-input-terminal 602;
the gate of the second CCC NMOS FET 623 is connected to the current-comparator-circuit-input-terminal 602.

The CCC-output-node 624 is connected to the current-comparator-circuit-output terminal 603. In this example, the current-comparator-circuit 601 also includes an inverter 625, which is connected in series between the CCC-output-node 624 and the current-comparator-circuit-output terminal 603. Therefore, the CCC-output-node 624 is indirectly connected to the current-comparator-circuit-output terminal 603 via the inverter 625.

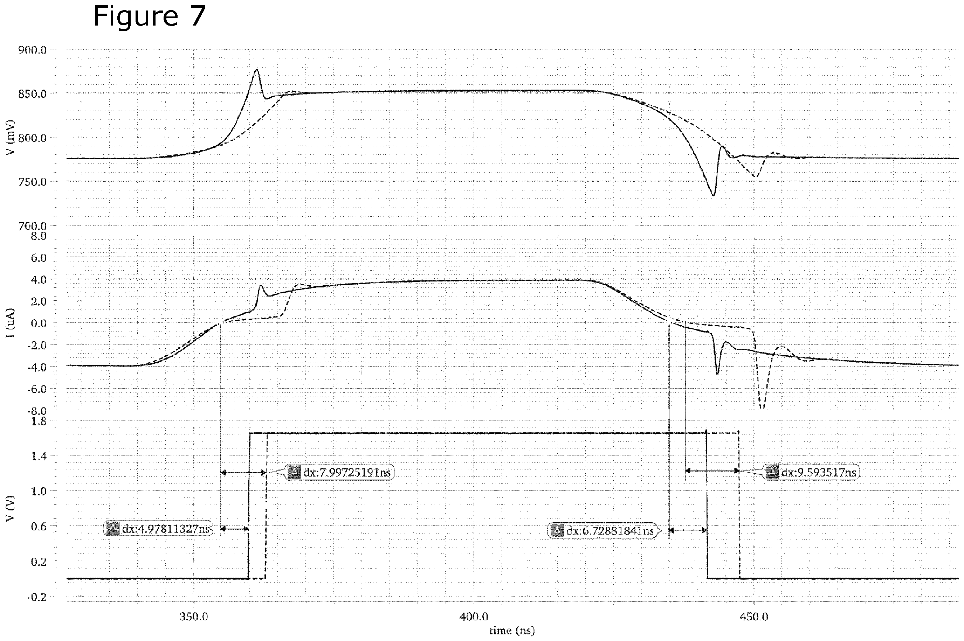

Figure 7 shows plots of the transient response of input current / voltage and output voltage of: the current comparator of Figure 6 in SOLID lines; and a circuit that does not include the PMOS FET and the NMOS FET of Figure 6 (that is, a circuit that is similar to that of Figure 2a) in DASHED lines.

For the simulations that are illustrated, the delays associated with the current comparator of Figure 6 are 30% less than those associated with a current comparator that does not include the PMOS FET and the PMOS FET. Furthermore, the resulting design after LPE showed only +10% delays degradation for the current comparator of Figure 6, as opposed to typical values +50% delay increase after LPE for a current comparator that does not include the PMOS FET and the PMOS FET.

Returning to Figure 6, the NMOS FET 614 and the PMOS FET 615 can have a minimum size, channel width and especially channel length, that is permitted for considered signal currents and for the technology of the integrated circuit. It is known in the art that there is a minimum size that a FET can have for any given technology, and that the minimum sizes may be different for different technologies. Therefore, the NMOS FET 614 and the PMOS FET 615 can be implemented as common gate input devices that have minimum size, as much as possible for the signal currents that are intended to be processed by the current comparator 600, and are located directly at the input of the current-comparator-circuit 601. In this way, they are not constrained by matching with some other devices and therefore do no provide the functionality of a cascode. Cascoding can be used to improve output impedance and accuracy of the output current of current mirrors, which constrains their minimum size. Cascode transistors cannot be made small because they require a certain channel length and matching between weighted outputs in order to function as a cascode. Cascode transistors also have constraints on bias, sizing and layout placements, which is not the case for the PMOS FET 614 and the NMOS FET 615 of Figure 6.

Advantageously, the common gate devices (i.e., the PMOS FET 614 and the NMOS FET 615), together with a local or shared bias circuit 613 can be provided with the current-comparator-circuit 601 as a single schematic block. Such a single schematic block can be provided on an integrated circuit (IC).

Current comparators with voltage-current feedback can achieve speed improvements by reducing input voltage swing, while their input capacitance and its effect on speed remains unchanged and can be a limiting factor. Current comparators with low input impedance, due to current mirrors/common gate input stage, can increase signal bandwidth on its input at the expense of increased power consumption and lower resolution because of a lower transimpedance gain. One or more of the examples disclosed herein can combine both of these techniques, to further enhance operational speed by decreasing effective input capacitance. This can be achieved by decoupling external capacitances from the current comparator's input to low impedance nodes. Also, it can result in the current comparator's circuitry being immune (or least less sensitive) to parasitic capacitances of routing estimated by Layout Parasitics Extraction (LPE).

Examples of the current comparator circuits disclosed herein can further enhance operational speed of a current comparator that uses voltage-current feedback by decreasing the effective capacitance on its input. Two common gate stages can be utilized to decouple the input away from external capacitances, those become connected to low impedance nodes of two new input terminals.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computerreadable or computer-usable storage media or mediums. Such computerreadable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A current comparator comprising:

   a first comparator input terminal, which is configured to receive a first current input signal;
   a second comparator input terminal, which is configured to receive a second current input signal;
   a comparator output terminal;
   a P-type metal oxide semiconductor field effect transistor, PMOS FET, and an N-type metal oxide semiconductor field effect transistor, NMOS FET, each having a gate, a drain and a source, wherein:

   the source of the PMOS FET is connected to the first comparator input terminal;
the source of the NMOS FET is connected to the second comparator input terminal;
the drain of the PMOS FET is connected to a current-comparator-input-node;
the drain of the NMOS FET is connected to the current-comparator-input-node;
the gate of the PMOS FET is connected to a first bias-voltage-node;
the gate of the NMOS FET is connected to a second bias-voltage-node;

a bias circuit that is configured to provide a bias voltage to each of the first and second bias-voltage-nodes; and
a current-comparator-circuit, comprising a current-comparator-circuit-input-terminal and a current-comparator-circuit-output terminal, wherein:

   the current-comparator-circuit-input-terminal is connected to the current-comparator-input-node in order to receive a difference-current-input signal, which is representative of the difference between the first current input signal and the second current input signal;
   the current-comparator-circuit-output terminal is connected to the comparator output terminal in order to provide a current comparator output signal; and
   the current-comparator-circuit is configured to provide the current comparator output signal as a digital voltage signal based on the received difference-current-input signal.

2. The current comparator of claim 1, wherein the current comparator is a continuous time current comparator.

3. The current comparator of claim 1 or claim 2, wherein the current-comparator-circuit is configured to implement voltage-current feedback.

4. The current comparator of any preceding claim, wherein the bias circuit is configured to provide the bias voltages such that the PMOS FET and the NMOS FET are maintained in a saturation region during operation of the current comparator.

5. The current comparator of any preceding claim, wherein the current comparator is provided on an integrated circuit.

6. The current comparator of claim 5, wherein the NMOS FET and the PMOS FET have a minimum size that is permitted for the signal currents that are intended to be processed by the current comparator and for the technology of the integrated circuit.

7. The current comparator of any preceding claim, wherein the NMOS FET and the PMOS FET are adjacent to the current-comparator-circuit on the integrated circuit.

8. The current comparator of any preceding claim, wherein the current-comparator-circuit comprises: a first current-comparator-circuit, CCC, NMOS FET, a first CCC PMOS FET, a second CCC PMOS FET, a second CCC NMOS FET, and a CCC-output-node wherein:

the drain of the first CCC NMOS FET is connected to a voltage supply terminal; the source of the first CCC NMOS FET is connected to the current-comparator-circuit-input-terminal; the source of the first CCC PMOS FET is connected to the current-comparator-circuit-input-terminal; the drain of the first CCC PMOS FET is connected to a ground terminal; the gate of the first CCC PMOS FET is connected to the CCC-output-node; the gate of the first CCC NMOS FET is connected to the CCC-output-node; the source of the second CCC PMOS FET is connected to the voltage supply terminal; the drain of the second CCC PMOS FET is connected to the CCC-output-node; the drain of the second CCC NMOS FET is connected to the CCC-output-node; the source of the second CCC NMOS FET is connected to the ground terminal; the gate of the second CCC PMOS FET is connected to the current-comparator-circuit-input-terminal; the gate of the second CCC NMOS FET is connected to the current-comparator-circuit-input-terminal; and the CCC-output-node is connected to the current-comparator-circuit-output terminal.

9. The current comparator of claim 8, wherein the current-comparator-circuit further comprises an inverter, which is connected in series between the CCC-output-node and the current-comparator-circuit-output terminal.

10. The current comparator of any preceding claim, further comprising one more further current-comparator modules, wherein each of the one more further current-comparator modules comprises:

a first module input terminal, which is configured to receive a first module current input signal; a second module input terminal, which is configured to receive a second module current input signal; a module output terminal; a P-type metal oxide semiconductor field effect transistor, PMOS FET, and an N-type metal oxide semiconductor field effect transistor, NMOS FET, each having a gate, a drain and a source, wherein:

the source of the PMOS FET is connected to the first module input terminal; the source of the NMOS FET is connected to the second module input terminal; the drain of the PMOS FET is connected to a current-comparator-module-input-node; the drain of the NMOS FET is connected to the current-comparator-module-input-node; the gate of the PMOS FET is connected to the first bias-voltage-node; the gate of the NMOS FET is connected to the second bias-voltage-node; and

a current-comparator-module-circuit, comprising a current-comparator-module-circuit-input-terminal and a current-comparator-module-circuit-output terminal, wherein:

the current-comparator-module-circuit-input-terminal is connected to the current-comparator-module-input-node in order to receive a module-difference-current-input signal, which is representative of the difference between the first module current input signal and the second module current input signal; the current-comparator-module-circuit-output terminal is connected to the module output terminal in order to provide a current comparator module output signal; and the current-comparator-module-circuit is configured to provide the current comparator module output signal as a digital voltage signal based on the received module-difference-current-input signal.

11. The current comparator of any preceding claim, wherein: the bias circuit is configured to provide a different bias voltage to each of the first and second bias-voltage-nodes.

12. The current comparator of any one of claims 1 to 10, wherein: the bias circuit is configured to provide the same bias voltage to each of the first and second bias-voltage-

**EP 4 564 668 A1**

nodes.

## Figure 1

## Figure 2a

## Figure 2b

## Figure 2c

# Figure 3

Multiple outpus current mirror #1

Multiple outpus current mirror #2

Cpar CC #1 Cpar CC #2 Cpar CC #N

Multiple outpus current mirror #3

Multiple outpus current mirror #4

# Figure 4a

$V_b$

$M_b$

$I_{ref}$

A

$M_3$

D

$M_1$

B

$M_2$

$M_5$

C

$M_4$

$I_{in}$

Figure 4b

# Figure 5

# Figure 6

Figure 7

Europäisches
Patentamt

European
Patent Office

Office européen
des brevets

# EUROPEAN SEARCH REPORT

**Application Number**

EP 23 21 2979

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HONG-YI HUANG ET AL: "Differential bidirectional transceiver for on-chip long wires", MICROELECTRONICS JOURNAL, MACKINTOSH PUBLICATIONS LTD. LUTON, GB, vol. 42, no. 11, 1 August 2011 (2011-08-01), pages 1208-1215, XP028306998, ISSN: 0026-2692, DOI: 10.1016/J.MEJO.2011.08.001 [retrieved on 2011-09-03] * page 1211 - page 1212; figures 4,6 * | 1-12 | INV. H03K5/24 |
| X | BCHIR MOUNIRA ET AL: "A Novel High-Performance ADC Flash Based on Bulk-Driven Quasi-Floating Gate Current Mirror", 2020 17TH INTERNATIONAL MULTI-CONFERENCE ON SYSTEMS, SIGNALS & DEVICES (SSD), IEEE, 20 July 2020 (2020-07-20), pages 780-785, XP033883641, DOI: 10.1109/SSD49366.2020.9364089 [retrieved on 2021-02-25] | 1-11 | |
| A | * Section II. B.; figures 3, 4 * | 12 | TECHNICAL FIELDS SEARCHED (IPC) H03K G01R |
| X | BCHIR MOUNIRA ET AL: "Low voltage low power current comparator circuit", 2017 18TH INTERNATIONAL CONFERENCE ON SCIENCES AND TECHNIQUES OF AUTOMATIC CONTROL AND COMPUTER ENGINEERING (STA), IEEE, 21 December 2017 (2017-12-21), pages 168-172, XP033330225, DOI: 10.1109/STA.2017.8314947 [retrieved on 2018-03-12] | 1-11 | |
| A | * Section II.; figure 1 * | 12 | |

The present search report has been drawn up for all claims

| Place of search | Date of completion of the search | Examiner |
|---|---|---|
| Munich | 14 May 2024 | Martínez Martínez, J |

EPO FORM 1503 03.82 (P04C01)